# EUROPEAN PATENT APPLICATION

(11) **EP 4 576 961 A1**
(43) Date of publication of application: **25.06.2025**
(21) Application number: 23307381.6
(22) Date of filing: 22.12.2023
(51) Int. Cl.: H05K 7/20

(54) **PRIORITIZED LIQUID COOLING ARRANGEMENTS FOR DATACENTER SERVER RACKS**

(71) Applicant: OVH, 59100 Roubaix (FR)
(72) Inventor: BAUDUIN, Hadrien, 59650 Villeneuve d'Ascq (FR); CHEHADE, Ali, 59283 Moncheaux (FR)
(74) Representative: BCF Global

(57) **Abstract**

A liquid cooling arrangement for cooling a server rack housing a plurality of server clusters containing heat-generating processing assemblies with liquid cooling units is presented. The cooling arrangement comprises a liquid distribution loop supplying a cooling liquid to the server clusters and returning a heated liquid from the server clusters with heat exchangers fluidly connected to a supply side of the liquid distribution loop. The server rack comprises a high priority server cluster containing processing components with high heat-generating temperature profiles and fluidly connected in parallel with the heat exchangers, and standard priority server clusters containing processing components with lower heat-generating temperature profiles and positioned further downstream along the liquid distribution loop and configured to receive liquid egressing out of the high priority server cluster, in which the high priority server cluster is arranged to have priority access to the supplied cooling liquid over the standard priority server cluster.

## Description

### FIELD OF TECHNOLOGY

The present technology relates to datacenter server rack liquid cooling configurations.

### BACKGROUND

Datacenters are configured to house multitudes of server racks containing electronic equipment, such as computer systems (e.g., server assemblies), memory banks, etc. in efforts to process vast amounts of data in near real time. During operations, the electronic equipment of the server racks generates a significant amount of heat that must be dissipated in order to ensure continued efficient operation of the electronic equipment. Many cooling solutions have been implemented to address this heating issue, including the liquid cooling of heat-generating components by way of liquid cooling blocks directly mounted onto certain heat-generating components (often referred to as liquid or water block units).

Although water block units are capable of efficiently cooling the heat-generating components, their implementation in server racks typically requires a liquid distribution infrastructure to service the multitude of server racks and the vast number of electronic equipment supported therein. Moreover, certain server racks contain servers with high-performance electronic processing components that generate higher-generating temperature profiles as opposed to other servers containing electronic components that do not generate higher temperature profiles.

It will be appreciated that liquid cooling distribution infrastructures conventionally require the use of extensive piping conduit implementations that span across the data center as well as numerous pumps to maintain the necessary cooling liquid flow rates to supply the multitude of water blocks, especially for the high-performance electronic processing components. The use of extensive piping conduit implementations and numerous pumps can be prohibitively costly for datacenters, in terms of initial investments and operating costs.

As a result, it appears to be desirable to provide a liquid cooling arrangement for datacenter server racks that can alleviate at least some of the cost prohibitive issues regarding conventional piping conduit implementations and pumps by providing a configuration that effectively addresses the cooling needs of both, servers having processing assemblies generating higher temperature profiles due to electronic components and servers having processing assemblies generating standard temperature profiles.

It is to be noted that the subject matter discussed in the background section should not be assumed to be prior art merely as a result of its mention in the background section. Similarly, the issues mentioned in the background section should not be interpreted as having been recognized in the prior art.

### SUMMARY

It is an object of the present technology to alleviate at least some of the cost prohibitive issues regarding that prevail in the prior art.

According to one aspect of the present technology, there is provided a liquid cooling arrangement for cooling a server rack housing a plurality of server clusters that each contain heat-generating processing assemblies with liquid cooling units, comprising a liquid distribution loop configured to supply a cooling liquid to the server clusters from a liquid cooling facility and return a heated liquid from the server clusters back to the cooling facility; one or more heat exchangers fluidly connected to a supply side of the liquid distribution loop. The server rack comprises a cluster of high priority servers containing processing components with high heat-generating temperature profiles and fluidly connected in parallel to the one or more heat exchangers, and a cluster of standard priority servers containing processing components with lower heat-generating temperature profiles than the high priority server cluster and positioned further downstream along the liquid distribution loop than the high priority server cluster and configured to receive liquid egressing out of the high priority server cluster. The high priority server cluster is arranged to have priority access to the supplied cooling liquid over the standard priority server cluster.

In certain aspects, the one or more heat exchangers comprises a plurality of air-to-liquid heat exchangers that are arranged in a parallel configuration relative to the liquid distribution loop.

In other aspects, the high priority cluster comprises a plurality of clusters that are arranged in a parallel configuration relative to the liquid distribution loop and the standard priority cluster comprises a plurality of clusters that are arranged in a parallel configuration relative to the liquid distribution loop.

In additional aspects, the liquid ingressing into the high priority cluster is at first temperature, the liquid egressing out of the high priority cluster is at a second temperature that is higher than the first temperature, the liquid ingressing into the standard priority cluster is at the second temperature, and the liquid egressing out of the standard priority cluster is at a third temperature that is higher than the second temperature.

In certain aspects, the standard priority cluster receives the liquid egressing out of the high priority cluster and the heat exchangers via the liquid distribution loop. While in other aspects, the standard priority cluster receives the liquid egressing out of the high priority cluster directly from a serial fluid connection that is independent from the one or more heat exchangers.

In yet other aspects, one of the heat exchangers comprises a primary and a secondary side, in which the primary and secondary sides of the heat exchangers are fluidly connected in parallel with each another and the high priority cluster is fluidly connected in series with the primary side or the secondary side of a given one of the heat exchangers while remaining in parallel with the remaining heat exchangers.

Implementations of the present technology each have at least one of the above-mentioned objects and/or aspects, but may not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1 depicts a functional block diagram of an internal server cluster configuration of a datacenter server rack, in accordance with the non-limiting embodiments of the present disclosure;
FIG. 2 depicts a functional block diagram of a liquid cooling arrangement that optimizes cooling efficiency by prioritizing server clusters within a datacenter rack, in accordance with some non-limiting embodiments of the present disclosure;
FIG. 3 depicts a functional block diagram of an alternative liquid cooling arrangement that optimizes cooling efficiency by prioritizing server clusters within a datacenter rack, in accordance with some non-limiting embodiments of the present disclosure; and
FIG. 4 depicts a functional block diagram of another alternative liquid cooling arrangement that optimizes cooling efficiency prioritizing server clusters within a datacenter rack, in accordance with some non-limiting embodiments of the present disclosure.

### DETAILED DESCRIPTION

The instant disclosure is directed to addressing at least some of the issues associated with the conventional use of various piping conduit configurations and numerous pumps to supply the liquid flows to the water blocks servicing the cooling needs of the multitude of heat-generating components. In particular, the instant disclosure presents embodiments of liquid cooling arrangements that prioritize higher heat generating servers to optimize the cooling thereof while streamlining liquid-cooling piping conduit arrangements.

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative systems embodying the principles of the present technology.

With these fundamentals in place, we will now consider some non-limiting examples to illustrate the implementations of the various inventive aspects of the present disclosure.

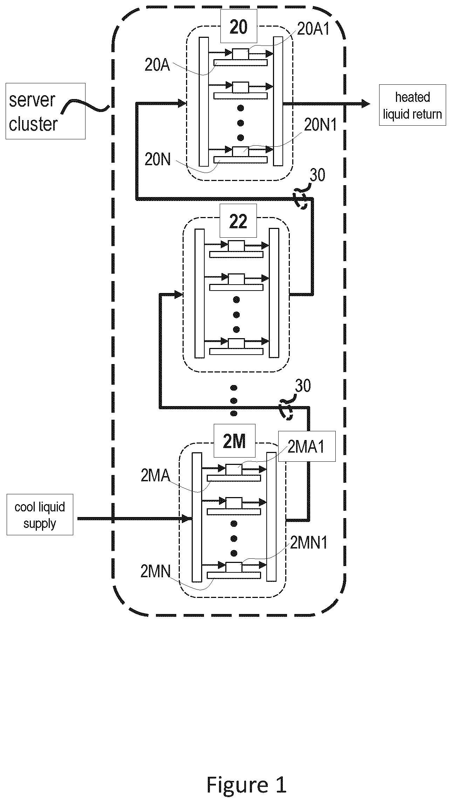

FIG. 1 depicts a functional block diagram of a representative internal server cluster 10 configuration of a datacenter server rack, in accordance with the non-limiting embodiments of the present disclosure. The representative server cluster 10 configuration comprises a plurality of server sub-clusters **20-2M**, in which each server sub-cluster **20-2M** correspondingly comprises a plurality of data processing assemblies **20A-20N** to **2MA-2MN** containing heat-generating electronic processing components.

As shown, each of the data processing assemblies **20A-20N** to **2MA-2MN** incorporates at least one respective liquid cooling block unit **20A1-20N1** to **2MA1-2MN1** disposed in direct thermal contact with the heat-generating electronic processing components. Each of the liquid cooling block units **20A1-20N1** to **2MA1-2MN1** is configured with internal conduits (*not shown*) to accommodate the circulated flow of channelized cooling liquid therethrough. The channelized cooling liquid is provided by a cooling liquid supply that is serially conveyed to each of the liquid cooling block units **20A1-20N1** to **2MA1-2MN1** via an internal server cluster liquid circulating channel **30** to absorb the thermal energy from the heat-generating electronic components and discharge the heated liquid therefrom.

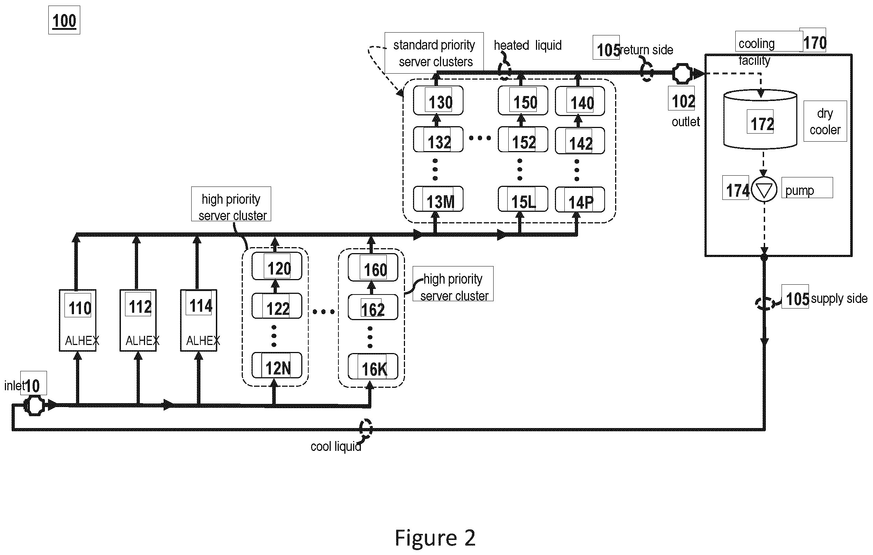

Given the internal datacenter server cluster **10** configuration described above, FIG. 2 depicts a functional block diagram of a liquid cooling arrangement **100** that optimizes overall cooling efficiency by prioritizing server clusters of a datacenter rack, in accordance with non-limiting embodiments of the present disclosure. While the embodiments and implementations described herein are directed to a datacenter rack, it will be appreciated that extending such concepts to encompass multiple datacenter racks are clearly within the scope of the present technology.

As shown, liquid cooling arrangement **100** comprises a single liquid distribution loop **105** configured with a supply side to supply a cooling liquid to the server clusters **120-12N**, **130-13M, 140-14P, 150-15L** of a rack from a liquid cooling facility **170** and a return side to return a heated liquid from the server clusters **120-15L** back to the cooling facility **170** for recooling and recirculation back to the server clusters **120-15L.** As noted above relative to FIG. 1, each of the server clusters **120-15L** comprise data processing assemblies (*see, e.g.,* FIG. 1 20A-20N to **2MA-2MN)** that incorporate at least one corresponding liquid cooling block unit for direct thermal contact with the heat generating electronic components of the data processing assemblies for dissipation of heat therefrom.

The liquid distribution loop **105** is configured with a liquid distribution inlet **101** along the supply side for supplying the cooling liquid to the fluidly-coupled server clusters **120-15L** and a liquid distribution outlet **102** along the return side for receiving a heated liquid from the server clusters **120-15L** and returning the heated liquid back to the cooling facility **170** for recooling and recirculation back to the server clusters **120-15L**. The liquid distribution loop **105** may be constructed from flexible materials (*e.g.*, rubber, plastic, *etc*.), rigid materials (*e.g*., metal, PVC piping, *etc*.), or any combination of thereof. It will be appreciated that the conveyed liquid may include water, alcohol, or any suitable liquid capable of sustaining adequate cooling temperatures.

The cooling facility **170** may comprise a dry cooler unit **172** configured to process and recondition received liquids from the server racks to provide cooling liquid for recirculation back to the server clusters **120-15L** via the liquid distribution loop **105**. The cooling facility **170** may further comprise a pump **174** configured to provide the necessary pressure increase and volume flow rate of the cooling liquid from the dry cooler unit **172** throughout the liquid distribution loop **105.**

The liquid cooling arrangement **100** further includes a plurality of air-to-liquid heat exchangers (ALHEXs) **110-114.** In the illustrated embodiment, the ALHEXs **110-114** are fluidly connected in parallel via the liquid cooling loop **105** while also being fluidly coupled to the server clusters **120-15L** via the liquid cooling loop **105.** It will be appreciated, however, that the ALHEXs **110-114** may be fluidly interconnected in other configurations, such as, for example, in series via the liquid cooling loop **105** without departing from the concepts of the disclosed technology.

The ALHEXs **110-114** function to sufficiently cool the ambient air surrounding the server clusters **120-15L**. The ALHEXs **110-114** may embody any suitable configuration that reduces liquid temperatures through supplied air flow (e.g. by compact fans), such as, internal cooling coils, heat extracting air flow fins, *etc.* The ALHEXs **110-114** may be, for example, disposed on rear doors of the rack hosting the server clusters **120-15L**, to directly cool the air exiting the server clusters **120-15L**, warmed by the air-cooled components therein.

As noted above, certain servers containing high-performance electronic processing components experience higher-generating temperature profiles than other servers. Also, as a general rule, liquid cooled components arranged in parallel decrease the fluid pressure drop experienced by the liquid distribution loop **105**, thereby allowing the pump **174** to operate efficiently in providing adequate flow rates circulating throughout the liquid distribution loop **105**.

In view of these operational factors, the liquid cooling arrangement **100** provides a configuration in which one or more server clusters incorporating high-performance electronic processing components are designated to be "high priority" server clusters while server clusters not incorporating high-performance electronic processing components are designated to be "standard priority" server clusters. In certain implementations, the electronic processing components of the servers are enclosed inside a casing thermally connected to the water blocks ; the high priority server clusters may require operational upper casing temperatures below approximately 60°C while standard priority server clusters may require operational upper casing temperatures ranging from approximately 70°C to 85°C. Moreover, the high priority server clusters are strategically positioned in parallel with ALHEXs to optimize cooling of the high priority server clusters while efficiently maintaining satisfactory flow rates circulating throughout the liquid distribution loop **105.**

That is, as shown in FIG. 2, the liquid cooling arrangement **100** configures the one or more high priority server clusters **120-12N** and **160-16K** to be arranged in parallel manner and in fluid connection with the ALHEXs **110-114** via the liquid distribution loop **105.** The configuration also positions the one or more high priority server clusters **120-12N** and **160-16K** in close proximity to the ALHEXs **110-114.** In this configuration, the one or more high priority server clusters **120-16K** are situated to first receive the "coldest" cooling liquid provided by the liquid distribution loop **105** to specifically address the particular cooling needs of the high priority server clusters **120-12N-160-16K.**

After the "coldest" cooling liquid is internally circulated through each of the data processing assemblies of the one or more high priority server clusters **120-16K**, the liquid egressing out of the high priority server clusters **120-16K** is then supplied to the "standard priority" server clusters **130-13M**, **140-14P**, **150-15L** for cooling therein via the liquid distribution loop **105.** Like the high priority server clusters **120-16K**, the standard priority server clusters **130-15L** are arranged in a parallel manner via the liquid cooling loop **105.**

While the liquid egressing from the high priority server clusters **120-16K**, via the liquid distribution loop **105**, will typically be warmer than the "coldest" cooling liquid due to the respective heat-generating processing assemblies, the temperature of the "warm" liquid will generally remain at levels that sufficiently cool the standard priority server clusters **130-15L.** This is due to the fact that the standard priority server clusters **130-15L** do not employ high-performance electronic processing components having higher-generating temperature profiles that require a lower temperature (*i.e*., "coldest") cooling liquid. In certain implementations, the coldest liquid temperature may range from approximately 25°C to 35°C while the warm liquid temperature may range from approximately 35°C to 45°C.

After the "warm" liquid has been internally circulated through each of the data processing assemblies and cooling units of the standard priority server clusters **130-15L**, the liquid egressing out of the standard priority server clusters **130-15L** is heated. The "heated" liquid is forwarded to the return side of the liquid distribution loop **105** for return back to the cooling facility **170** for recooling and recirculation back to all the server clusters **120-15L**. In certain implementations, the heated liquid temperature may range from approximately 45°C to 65°C.

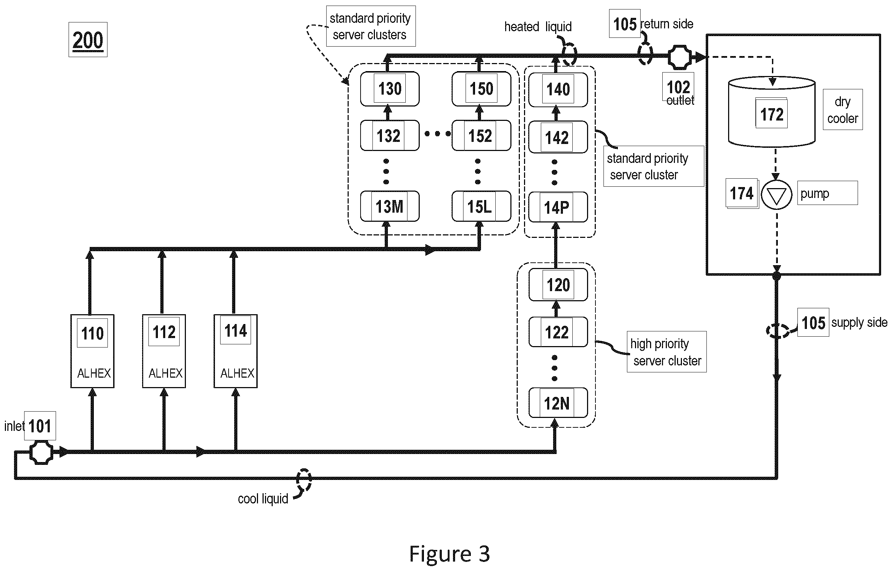

FIG. 3 depicts a functional block diagram of an alternative liquid cooling arrangement **200** that also optimizes cooling efficiency by prioritizing server clusters within a datacenter rack, in accordance with some non-limiting embodiments of the present disclosure. Because the liquid cooling arrangement **200** contains similar components with like reference numerals as arrangement **100**, for the sake of brevity, detailed descriptions of such components will not be repeated unless necessary for the understanding of the embodiment.

Like liquid cooling arrangement **100**, the liquid cooling arrangement **200** includes a high priority server clusters **120-12N**, a plurality of standard priority server clusters **130-15L** and a liquid distribution loop **105** for conveying the circulatory flow of cooling liquid throughout the respective processing assemblies and cooling units of the server clusters.

The liquid cooling arrangement **200** also includes a plurality of ALHEXs **110-114** that are configured in a parallel manner relative to the liquid distribution loop **105.** As noted above, ALHEXs **110-114** function to sufficiently cool the ambient air surrounding the server clusters **120-15L** (*e.g.,* by being disposed on rear doors for cooling directly the air exiting the server clusters **120-15L**, warmed by the air-cooled components therein).

However, unlike liquid cooling arrangement **100**, the liquid cooling arrangement **200** segregates the standard priority server clusters **130-15L** into two or more standard priority server groupings such as, for example, a first grouping: clusters **130-13M** - **150-15L**; and a second grouping: clusters **140-14P.** As shown, the first standard priority server grouping arranges the clusters **130-13M** and **150-15L** in parallel with each other, in which the clusters are fluidly coupled to the liquid distribution loop **105** for receiving the warmed cooling liquid provided by the ALHEXs **110-114.**

In turn, the second standard priority server grouping (*i.e.,* clusters **140-14P**) serially and directly receives the liquid egressing from the high priority server cluster **120-12N** for cooling purposes. That is, the high priority server cluster **120-12N** is fluidly-coupled to the liquid distribution loop **105** on the supply side to receive the "coldest" cooling liquid and internally circulates the liquid throughout the respective processing assemblies and cooling units of the high priority server cluster **120-12N.** And, as noted above, while the liquid egressing from the high priority server cluster **120-12N** will typically be warmer than the "coldest" cooling liquid due to the respective high heat-generating processing assemblies, the temperature of the "warm" liquid will generally still be at levels to sufficiently cool the second standard priority server grouping (*i.e.,* clusters **140-14P**). For certain cluster configurations, liquid cooling arrangement **200** provides the advantage of being quicker and/or easier to implement than cooling arrangement **100.**

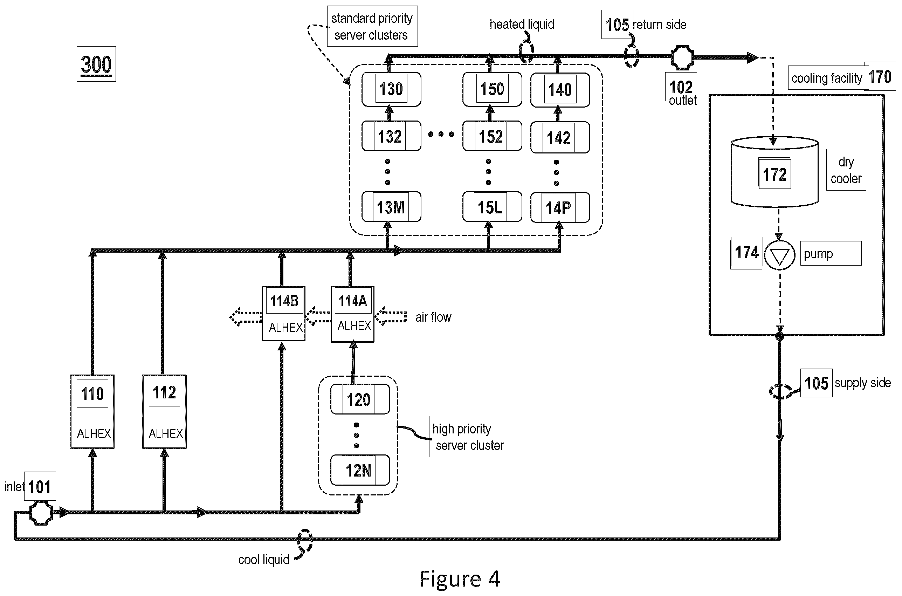

FIG. 4 depicts a functional block diagram of another alternative liquid cooling arrangement **300** that also optimizes cooling efficiency by prioritizing server clusters within a datacenter rack, in accordance with some non-limiting embodiments of the present disclosure. Because the liquid cooling arrangement **300** contains similar components with like reference numerals as arrangement **100**, for the sake of brevity, detailed descriptions of such components will not be repeated unless necessary for the understanding of the embodiment.

Like liquid cooling arrangement **100**, the liquid cooling arrangement **300** includes a high priority server cluster **120-12N**, a plurality of standard priority server clusters **130-15L**, a liquid distribution loop **105** for conveying the circulatory flow of cooling liquid throughout the server clusters, and a plurality of ALHEXs **110-114** that are arranged in a parallel manner relative to the liquid distribution loop **105.**

As noted above, the ALHEXs **110-114** function to sufficiently cool the ambient air surrounding all of the server clusters **120-15L** (*e.g.,* by being disposed on rear doors for cooling directly the air exiting the server clusters **120-15L**, warmed by the air-cooled components therein). It will be appreciated that each of the ALHEXs **110-114** may comprise a primary cooling side and a secondary cooling side, in which each side may operate independently with complementary cooling effects.

With this said, unlike liquid cooling arrangement **100**, liquid cooling arrangement **300** utilizes the capability that an ALHEX **114** may be divided into a ALHEX primary side **114A** and a secondary side **114B**, in which a high priority server cluster **120-12N** is serially fluidly-coupled a side of the ALHEX **114B.**

In particular, as shown, high priority server cluster **120-12N** receives the "coldest" cooling liquid via the liquid distribution loop **105.** The cooling liquid is then internally circulated liquid throughout the respective processing assemblies and cooling units of the high priority cluster **120-12N** which results in a "warm" liquid egressing from the high priority server cluster **120-12N.** The warm liquid is serially forwarded to an ALHEX **114B** side for cooling which is then supplied to liquid distribution loop **105** for the liquid cooling of standard priority server clusters **130-15L.** With this configuration, liquid cooling arrangement **300** provides the advantage of maximizing liquid flow rates through the high priority cluster.

The air flows in the direction of arrows depicted on FIG. 4. Upon entering the ALHEX primary side **114A**, a temperature of the airflow is high due to the generation of heat in the server rack. A temperature of the liquid flowing through the ALHEX primary side **114A** may then further increase, being continuously exposed to the said airflow. The airflow between the ALHEX primary side **114A** and the ALHEX secondary side **114B** may have a stratified, heterogeneous temperature profile. The same airflow immediately reaches the ALHEX secondary side **114B.** In this implementation, cold liquid is directly received by the ALHEX secondary side **114B** from the inlet 101. The air flow thus exits the ALHEX secondary side **114B** at a lowered temperature and may thus be redirected to the server rack for cooling thereof.

In this manner, each of the presented liquid cooling arrangements **100**, **200**, **300** provide configurations that optimize the overall cooling efficiency by separately addressing the liquid cooling needs of high priority server clusters and standard priority server clusters.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A liquid cooling arrangement (100, 200, 300) for cooling a server rack housing a plurality of server clusters (120-12N, 160-16K, 130-13M, 140-14P, 150-15L) that each contain heat-generating processing assemblies with liquid cooling units, comprising:
a liquid distribution loop (105) configured to supply a cooling liquid to the server clusters (120-15L) from a liquid cooling facility (170) and return a heated liquid from the server clusters (120-15L) back to the cooling facility (170);
one or more heat exchangers (110-114) fluidly connected to a supply side of the liquid distribution loop (105);
the server rack comprising:
a cluster of high priority servers (120-12M, 160-16K) containing processing components with high heat-generating temperature profiles and fluidly connected in parallel to the one or more heat exchangers, and
a cluster of standard priority servers (130-15L) containing processing components with lower heat-generating temperature profiles than the high priority server cluster and positioned further downstream along the liquid distribution loop than the high priority server cluster and configured to receive liquid egressing out of the high priority server cluster,
wherein, the high priority server cluster is arranged to have priority access to the supplied cooling liquid over the standard priority server cluster.

2. The liquid cooling arrangement of claim 1, wherein the one or more heat exchangers comprises air-to-liquid heat exchangers.

3. The liquid cooling arrangement of claim 1 or 2, wherein the one or more heat exchangers comprises a plurality of heat exchangers arranged in a parallel configuration relative to the liquid distribution loop (105).

4. The liquid cooling arrangement of any one of claims 1 to 3, further comprising a pump (174) configured to control a flow of the liquid circulating throughout the liquid distribution loop (105).

5. The liquid cooling arrangement of anyone of claims 1 to 4, wherein the cooling facility (170) further comprises a dry cooler unit (172).

6. The liquid cooling arrangement of any one of claims 1 to 5, wherein the standard priority clusters are arranged in a parallel configuration relative to the liquid distribution loop (105).

7. The liquid cooling arrangement of any one of claims 1 to 6, wherein the liquid ingressing into the high priority cluster is at first temperature and the liquid egressing out of the high priority cluster is at a second temperature that is higher than the first temperature.

8. The liquid cooling arrangement of any one of claims 1 to 7, wherein the liquid ingressing into the standard priority cluster is at the second temperature and the liquid egressing out of the standard priority cluster is at a third temperature that is higher than the second temperature.

9. The liquid cooling arrangement of any one of claims 1 to 8, wherein the standard priority cluster receives the liquid egressing out of the high priority cluster and the heat exchangers via the liquid distribution loop.

10. The liquid cooling arrangement of any one of claims 1 to 9, wherein the standard priority cluster receives the liquid egressing out of the high priority cluster directly from a serial fluid connection that is independent from the one or more heat exchangers (110-114).

11. The liquid cooling arrangement of any one of claims 1 to 10, wherein a given one of the heat exchangers comprises a primary and a secondary side.

12. The liquid cooling arrangement of claim 11, wherein the primary and secondary sides of the heat exchangers are fluidly connected in parallel with one another.

13. The liquid cooling arrangement of claim 12, wherein the high priority cluster is fluidly connected in series with the primary side or the secondary side of a given one of the heat exchangers.

14. The liquid cooling arrangement of claim 13, wherein the high priority cluster and serially connected heat exchanger are arranged to be in parallel with the remaining heat exchangers.

## Amended claims

### Amended claims in accordance with Rule 137(2) EPC.

1. A liquid cooling arrangement (100, 200, 300) for cooling a server rack housing a plurality of server clusters (120-12N, 160-16K, 130-13M, 140-14P, 150-15L) that each contain heat-generating processing assemblies with liquid cooling units, comprising:
a liquid distribution loop (105) configured to supply a cooling liquid to the server clusters (120-15L) from a liquid cooling facility (170) and return a heated liquid from the server clusters (120-15L) back to the cooling facility (170);
one or more heat exchangers (110-114) fluidly connected to a supply side of the liquid distribution loop (105) the one or more heat exchangers comprising air-to-liquid heat exchangers;
the server rack comprising:
a cluster of high priority servers (120-12M, 160-16K) containing processing components with high heat-generating temperature profiles and fluidly connected in parallel to the one or more heat exchangers, and
a cluster of standard priority servers (130-15L) containing processing components with lower heat-generating temperature profiles than the high priority server cluster and positioned further downstream along the liquid distribution loop than the high priority server cluster and configured to receive liquid egressing out of the high priority server cluster,
wherein, the high priority server cluster is arranged to have priority access to the supplied cooling liquid over the standard priority server cluster; and
wherein the standard priority cluster receives the liquid egressing out of the high priority cluster and the heat exchangers via the liquid distribution loop.

2. The liquid cooling arrangement of claim 1, wherein the one or more heat exchangers comprises a plurality of heat exchangers arranged in a parallel configuration relative to the liquid distribution loop (105).

3. The liquid cooling arrangement of claim 1 to 2, further comprising a pump (174) configured to control a flow of the liquid circulating throughout the liquid distribution loop (105).

4. The liquid cooling arrangement of anyone of claims 1 to 3, wherein the cooling facility (170) further comprises a dry cooler unit (172).

5. The liquid cooling arrangement of any one of claims 1 to 4, wherein the standard priority clusters are arranged in a parallel configuration relative to the liquid distribution loop (105).

6. The liquid cooling arrangement of any one of claims 1 to 5, wherein the liquid ingressing into the high priority cluster is at first temperature and the liquid egressing out of the high priority cluster is at a second temperature that is higher than the first temperature.

7. The liquid cooling arrangement of any one of claims 1 to 6, wherein the liquid ingressing into the standard priority cluster is at the second temperature and the liquid egressing out of the standard priority cluster is at a third temperature that is higher than the second temperature.

8. The liquid cooling arrangement of any one of claims 1 to 7, wherein the standard priority cluster receives the liquid egressing out of the high priority cluster directly from a serial fluid connection that is independent from the one or more heat exchangers (110-114).

9. The liquid cooling arrangement of any one of claims 1 to 8, additionally comprising further heat exchangers each comprising a primary and a secondary side.

10. The liquid cooling arrangement of claim 9, wherein the primary and secondary sides of the further heat exchangers are fluidly connected in parallel with one another.

11. The liquid cooling arrangement of claim 10, wherein the high priority cluster is fluidly connected in series with the primary side or the secondary side of a given one of the further heat exchangers.

12. The liquid cooling arrangement of claim 11, wherein the high priority cluster and serially connected heat exchanger are arranged to be in parallel with the remaining further heat exchangers.
